# EUROPEAN PATENT APPLICATION

(11) **EP 4 661 606 A1**
(43) Date of publication of application: **10.12.2025**
(21) Application number: 24838300.2
(22) Date of filing: 28.02.2024
(51) Int. Cl.: H05K 5/06

(54) **FOLDABLE STRUCTURAL MEMBER AND PREPARATION METHOD THEREFOR, AND FOLDABLE ELECTRONIC DEVICE**

(30) Priority: 11.07.2023 CN 202310851721
(71) Applicant: Honor Device Co., Ltd., Shenzhen, Guangdong 518040 (CN)
(72) Inventor: LI, Chunyang, Shenzhen, Guangdong 518040 (CN); TAN, Dongsheng, Shenzhen, Guangdong 518040 (CN); MIAO, Yuan, Shenzhen, Guangdong 518040 (CN); XUE, Kangle, Shenzhen, Guangdong 518040 (CN); WANG, Ya, Shenzhen, Guangdong 518040 (CN); GAO, Shanhui, Shenzhen, Guangdong 518040 (CN)
(74) Representative: Goddar, Heinz J.
(86) International application number: PCT/CN2024/079076
(87) International publication number: WO 2025/011039

(57) **Abstract**

Embodiments of this application provide a foldable structural member, a manufacturing method thereof, and a foldable electronic device. The foldable structural member includes a first middle frame and a second middle frame, a first protective layer and an injection molding layer that are successively stacked in corresponding regions of the first middle frame and the second middle frame, and an anti-corrosion layer disposed between the injection molding layer and the first protective layer. The special anti-corrosion design provides feasibility for a magnesium alloy to be used as a metal body in a rotating open region of the foldable structural member, so that the structural member can be configured to provide a lighter and thinner foldable electronic device.

## Description

This application claims priority to Chinese Patent Application No. 202310851721.2, filed with the China National Intellectual Property Administration on July 11, 2023 and entitled "FOLDABLE STRUCTURAL MEMBER, MANUFACTURING METHOD THEREOF, AND FOLDABLE ELECTRONIC DEVICE", which is incorporated herein by reference in its entirety.

### TECHNICAL FIELD

This application relates to the field of electronic technologies, and in particular, to a foldable structural member, a manufacturing method thereof, and a foldable electronic device.

### BACKGROUND

With rapid development of electronic technologies, consumers increasingly pursue lightness and thinness of electronic devices such as mobile phones. Generally, a manufacturer chooses to assemble a magnesium alloy middle frame in an electronic device, so as to improve the lightness and thinness of the electronic device. However, for a currently popular foldable electronic device with a higher requirement for the lightness and thinness, a middle frame thereof generally includes a first middle frame and a second middle frame that are connected to a rotating mechanism. In this case, a rotating open region (including a region into which salt spray and water vapor can infiltrate) necessarily exists in the middle frame. If a full-magnesium alloy middle frame is still adopted, a conventional magnesium alloy anti-corrosion design fails to meet the requirement. In a salt spray environment, galvanic corrosion may occur in the rotating open region, resulting in blockage and failure of the rotating mechanism.

If an anti-corrosion solution, for a bar phone, of packaging the whole magnesium alloy middle frame with full adhesive in coordination with glue dispensing sealing is simply applied to the foldable structural member, the galvanic corrosion at the joint where the magnesium alloy in the rotating open region laps over a steel rotating shaft cannot be solved, resulting in a problem that the whole machine cannot pass a salt spray test. Therefore, product requirements cannot be met. Thus, it is urgently necessary to provide a foldable structural member with a brand-new anti-corrosion design, so as to implement feasibility of using the full-magnesium alloy middle frame in the foldable electronic device.

### SUMMARY

In view of this, embodiments of this application provide a foldable structural member, a manufacturing method thereof, and a foldable electronic device. The foldable structural member has a special anti-corrosion design, which provides feasibility for a magnesium alloy to be used as a metal body in a rotating open region of the foldable structural member.

A first aspect of the embodiments of this application provides a foldable structural member, including a rotating mechanism, and a first middle frame and a second middle frame that are rotatably connected to the rotating mechanism.

The first middle frame includes a first backplane, the first backplane having a first surface. The second middle frame includes a second backplane, the second backplane having a second surface, and the rotating mechanism lapping over the first surface and the second surface.

A first region and a second region are defined, the first region including a side border that is of the first surface and that is close to the rotating mechanism, and the second region including a side border that is of the second surface and that is close to the rotating mechanism.

The first backplane and the second backplane each include a metal body, a first protective layer disposed on a surface of the metal body, an injection molding layer disposed on at least a surface of the first protective layer in the first region and the second region, and an anti-corrosion layer disposed between the injection molding layer and the first protective layer.

The metal body provides structural strength for the first middle frame and the second middle frame, and plays a specific protective role. When the metal body is applied to the electronic device, the metal body may further serve to assist a processor of the electronic device to radiate heat. The first protective layer may protect the metal body, so as to prevent the metal body from being corroded. In particular, the injection molding layer in the first region and the second region may have a better sealing effect, that is, a risk of salt spray or water vapor infiltrating into the structural member is greatly reduced. Therefore, when a material of the metal body is a magnesium alloy, a risk of galvanic corrosion of the magnesium alloy body in the rotating open region can be sufficiently reduced. However, the anti-corrosion layer may significantly increase an interface bonding force between the first protective layer and the injection molding layer, and avoid a case that the injection molding layer and the first protective layer are poorly bonded and layered, thereby significantly reducing the risk of galvanic corrosion of the metal body, and then providing feasibility for applying a magnesium alloy middle frame (including the first middle frame and the second middle frame) to the foldable electronic device.

In some implementations of this application, the first backplane has a third surface opposite to the first surface and a fourth surface that connects the first surface to the third surface, the fourth surface including the anti-corrosion layer and the injection molding layer that are successively stacked on a surface that is of the first protective layer and that faces away from the metal body.

In some implementations of this application, the second backplane has a fifth surface opposite to the second surface, and a sixth surface that connects the second surface to the fifth surface, the sixth surface including the anti-corrosion layer and the injection molding layer that are successively stacked on a surface that is of the first protective layer and that faces away from the metal body.

In some implementations of this application, the first middle frame and the second middle frame further include a first side frame fastened to the first backplane and a second side frame fastened to the second backplane, respectively. The first side frame, the first backplane, the second backplane, and the second side frame constitute a first accommodating space. The first side frame and the second side frame are manufactured by injection molding. In this way, not only an anti-corrosion effect of the foldable structural member can be fully ensured, but also a limiting effect is implemented on a display in the final electronic device. In addition, an appearance surface of the final electronic device can be further constituted.

In some implementations of this application, the first side frame is integrally molded with the injection molding layer, and the second side frame is integrally molded with the injection molding layer. In this way, strength of the first middle frame and the second middle frame is improved, and manufacturing is also easy.

In some implementations of this application, a thickness of the first protective layer is within a range of 15 µm to 40 µm. In this way, an anti-corrosion effect of the first protective layer can be improved, and a risk of galvanic corrosion of the metal body is further reduced.

In some implementations of this application, the first protective layer is a porous structure, and the first protective layer has a porosity of less than or equal to 15% and an aperture of less than or equal to 20 µm. In this case, the first protective layer has a specific density, itself may implement a better anti-corrosion effect, and further may significantly increase a direct interface bonding force between the first protective layer and the anti-corrosion layer, thereby improving an integral anti-corrosion capability of the first middle frame and the second middle frame.

In some implementations of this application, the first protective layer is a ceramic layer formed by micro-arc oxidation. The ceramic layer manufactured by the micro-arc oxidation has high hardness, strong corrosion resistance and good insulation performance.

In some implementations of this application, a thickness of the injection molding layer is within a range of 0.15 mm to 0.35 mm. In this way, better sealing performance may be achieved, thereby improving a complete-machine anti-corrosion effect of the electronic device, and it can help ensure that the final electronic device is relatively light and thin.

In some implementations of this application, the injection molding layer is an inorganic material reinforced resin layer. Inorganic material reinforced resin has good mechanical performance, and has a good bonding force with a material of the first protective layer.

In some implementations of this application, the anti-corrosion layer is a resin layer. A material of the resin layer includes a cured product of an epoxy resin, a polyester resin and a silane coupling agent. A thickness of the anti-corrosion layer is within a range of 10 µm to 40 µm. In this way, the anti-corrosion layer can implement better corrosion resistance while taking into account the lightness and thinness of the final electronic device.

In some implementations of this application, the anti-corrosion layer includes a first resin layer and a second resin layer that are stacked, and the first resin layer is in contact with the first protective layer. The first resin layer includes a resin distributed with a first-type inorganic filler, the resin including a material prepared from an epoxy resin, a polyester resin, and a silane coupling agent, and the first-type inorganic filler including at least one of hydrophobic silicon dioxide, talc powder, and magnesium powder. The second resin layer includes a cured product of a first-type acrylic resin distributed with a second-type inorganic filler and an isocyanate, the second-type inorganic filler including at least one of silicon dioxide, barium sulfate, and titanium dioxide. In this way, corrosion resistance of the anti-corrosion layer can be further improved.

In some implementations of this application, a thickness of the first resin layer is within a range of 2 µm to 10 µm, and a thickness of the second resin layer is within a range of 10 µm to 30 µm. In this way, the anti-corrosion layer may implement better corrosion resistance.

In some implementations of this application, a transition layer is further disposed between the first resin layer and the second resin layer, the transition layer including a second-type hydroxyacrylic resin. The thickness of the first resin layer is within a range of 2 µm to 10 µm. The thickness of the second resin layer is within a range of 2 µm to 10 µm. A thickness of the transition layer is within a range of 10 µm to 20 µm. In this way, the anti-corrosion layer can implement better corrosion resistance while taking into account the lightness and thinness of the final electronic device.

In some implementations of this application, on the first surface, a second protective layer is further disposed in at least a part of a region that is on a surface on which the anti-corrosion layer is not covered by the injection molding layer and that is adjacent to the injection molding layer. In this way, a galvanic corrosion resistance effect of the rotating open region can be further improved.

In some implementations of this application, on the second surface, a second protective layer is further disposed in at least a part of a region that is on a surface on which the anti-corrosion layer is not covered by the injection molding layer and that is adjacent to the injection molding layer. In this way, the galvanic corrosion resistance effect of the rotating open region can be further improved.

In some implementations of this application, the second protective layer is connected to the injection molding layer.

In some implementations of this application, the second protective layer further covers a surface that is of the injection molding layer and that faces away from the anti-corrosion layer.

In some implementations of this application, the second protective layer includes a fluorine-containing resin, or the second protective layer includes a cured product of a third-type hydroxyacrylic resin and an isocyanate. The fluorine-containing resin also has specific hydrophobicity, and the cured product of a third-type hydroxyacrylic resin and an isocyanate has better compactness.

In some implementations of this application, a thickness of the second protective layer is within a range of 5 µm to 30 µm. In this way, the corrosion resistance and the lightness and thinness of the final electronic device can be considered.

In some implementations of this application, screw holes are disposed in the first region and the second region, the screw holes are adapted to screws, and the screws are configured to fasten the rotating mechanism.

In some implementations of this application, a material of the metal body is a magnesium alloy. In this way, a weight and a thickness of the foldable structural member can be significantly reduced while mechanical performance of the foldable structural member is ensured. When the foldable structural member is applied to the electronic device, market competitiveness of the electronic device can be greatly improved.

A second aspect of this application provides a manufacturing method of the foldable structural member, including:
providing a metal body, and forming the first protective layer on a surface of the metal body;
forming the anti-corrosion layer on at least a surface of the first protective layer in the first region and the second region; and
forming the injection molding layer on at least a surface of the anti-corrosion layer in the first region and the second region to manufacture the foldable structural member.

The manufacturing method has simple steps and high production efficiency, and is applicable to large-scale industrial production.

In some implementations of this application, a process of forming the first protective layer on a surface of the metal body includes:
soaking the metal body in an electrolyte in an electrolytic cell, using the metal body as an anode, using the electrolytic cell as a cathode, applying an electric field, and performing micro-arc oxidation on the metal body at a current density greater than 2 A and less than or equal to 5 A; where the electrolyte includes a solvent, a salt, and a nano additive; and the salt includes at least one of silicate, phosphate, and aluminate. In this way, a first protective layer with a thickness of 15 µm to 40 µm can be manufactured.

A third aspect of the embodiments of this application provides a foldable electronic device. The foldable electronic device includes the foldable structural member provided in the first aspect of the embodiments of this application.

In some implementations of this application, the foldable electronic device includes but is not limited to a wearable electronic device such as a mobile phone, a notebook computer, a tablet computer, and an electronic watch.

In some implementations of this application, the foldable electronic device includes a first display and a second display.

The first display is disposed on a first surface of the first middle frame and a second surface of the second middle frame. The first display is a flexible display.

The second display is disposed on a surface that is of the first middle frame and that faces away from the first display, or the second display is disposed on a surface that is of the second middle frame and that faces away from the first display.

### BRIEF DESCRIPTION OF DRAWINGS

FIG. 1A is a schematic diagram of a foldable structural member in an unfolded state according to an embodiment of this application;
FIG. 1B is a schematic diagram of the foldable structural member in FIG. 1A from another perspective;
FIG. 1C is a schematic diagram of the foldable structural member in FIG. 1B in another state;
FIG. 1D is a schematic diagram of a first backplane from a perspective according to an embodiment of this application;
FIG. 2A is a schematic diagram of a first middle frame and a second middle frame of a foldable structural member in an unfolded state according to an embodiment of this application;
FIG. 2B is a schematic diagram of a first middle frame and a second middle frame of a foldable structural member in an unfolded state according to another embodiment of this application;
FIG. 3A is a partially enlarged view of a first region on a first surface of a first middle frame according to an embodiment of this application;
FIG. 3B is a partially enlarged view of a first region on a first surface of a first middle frame according to another embodiment of this application;
FIG. 3C is a partially enlarged view of a first region on a first surface of a first middle frame according to still another embodiment of this application;
FIG. 3D is a partially enlarged view of a first region on a first surface of a first middle frame according to yet another embodiment of this application;
FIG. 4A is a schematic structural diagram of a cross section of a first middle frame according to an embodiment of this application;
FIG. 4B is a schematic structural diagram of a cross section of a first middle frame according to another embodiment of this application; and
FIG. 4C is a schematic structural diagram of a cross section of a first middle frame according to still another embodiment of this application.

### Descriptions of reference numerals:

100: foldable structural member; 10: first middle frame; 11: first backplane; 111: first surface; 112: third surface; 113: first region; 114: fourth surface; 12: first side frame; 20: second middle frame; 21: second backplane; 211: second surface; 212: fifth surface; 213: second region; 22: second side frame; 30: rotating mechanism; 40: metal body; 50: first protective layer; 60: anti-corrosion layer; 70: injection molding layer; and 80: second protective layer.

### DESCRIPTION OF EMBODIMENTS

At a current stage, in a mainstream foldable electronic device, two displays may be disposed at the same time, and one of the displays is a flexible screen and may correspondingly change with folding and unfolding of the electronic device. To achieve the foregoing objective, a middle frame of the electronic device needs to be disposed as a foldable structural member, and generally includes a first middle frame and a second middle frame that are connected by using a steel rotating mechanism. A first middle frame and a second middle frame are rotated around the rotating mechanism to implement folding and unfolding of the flexible display. Therefore, the flexible display needs to be attached to both a surface of the first middle frame and a surface of the second middle frame, so that the foldable electronic device cannot implement sealing between the middle frame and the screen in a screen glue dispensing manner like a bar phone (salt spray and water vapor corrosion resistance performance can be implemented). Therefore, the middle frame of the foldable electronic device necessarily has a rotating open region, which means that salt spray or water vapor may enter the region, thereby forming an electrolyte environment in the rotating open region.

In addition, a standard electrode potential (-2.37 V) of a magnesium alloy and the steel rotating mechanism (a potential of steel depends on a standard electrode potential of a main element Fe, about -0.44 V) are greatly different. In the electrolyte environment, the middle frame of the magnesium alloy and the steel rotating mechanism form an original battery circuit, and galvanic corrosion occurs. As an anode, the magnesium alloy loses electrons, resulting in corrosion perforation and local material shortage of the magnesium alloy to cause blockage and failure of the rotating mechanism. To avoid the foregoing problem, the aluminum alloy is directly selected in the industry as a material of the rotating open region in the middle frame. However, this reduces the lightness and thinness of the electronic device and cannot meet market requirements. To solve the foregoing problem, embodiments of this application provide a foldable structural member, and a special corrosion protection design of the foldable structural member can effectively solve a galvanic corrosion problem of the magnesium alloy in the foldable structural member.

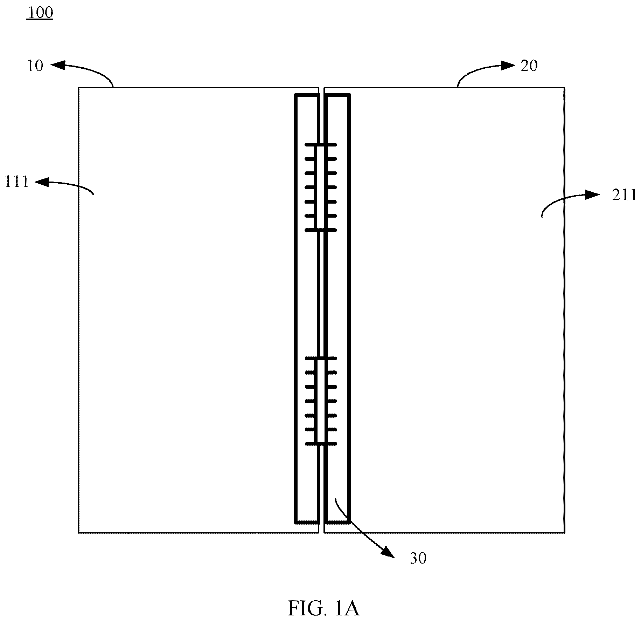

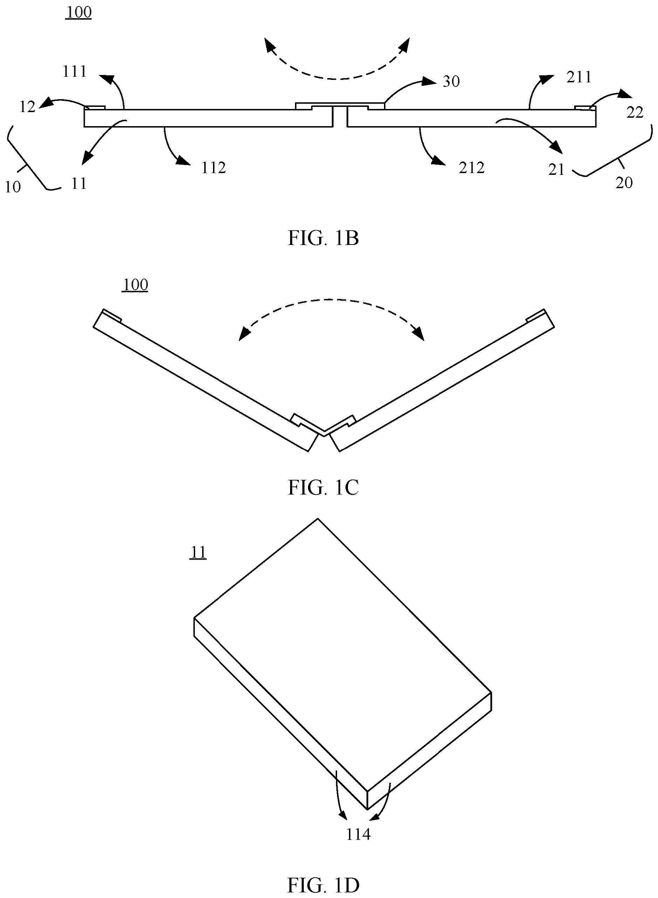

Referring to FIG. 1A to FIG. 3D, embodiments of this application provide a foldable structural member 100, including a rotating mechanism 30, and a first middle frame 10 and a second middle frame 20 that are rotatably connected to the rotating mechanism 30. In a process of unfolding and folding the foldable structural member 100, the first middle frame 10 and the second middle frame 20 rotate in a cambered dotted arrow direction in FIG. 1C around the rotating mechanism 30. When the foldable structural member 100 is fully unfolded, as shown in FIG. 1A and FIG. 1B, the first middle frame 10 and the second middle frame 20 are disposed on two opposite sides of the rotating mechanism 30, respectively.

The first middle frame 10 includes a first backplane 11, the first backplane 11 having a first surface 111. The second middle frame 20 includes a second backplane 21, the second backplane 21 having a second surface 211, and the rotating mechanism 30 lapping over the first surface 111 and the second surface 211.

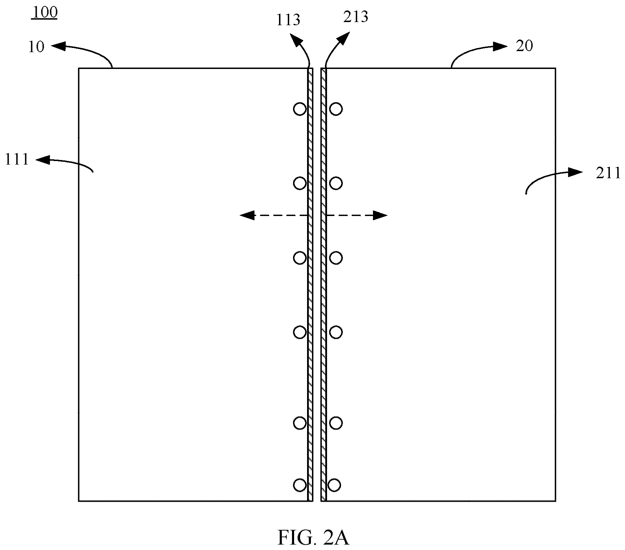

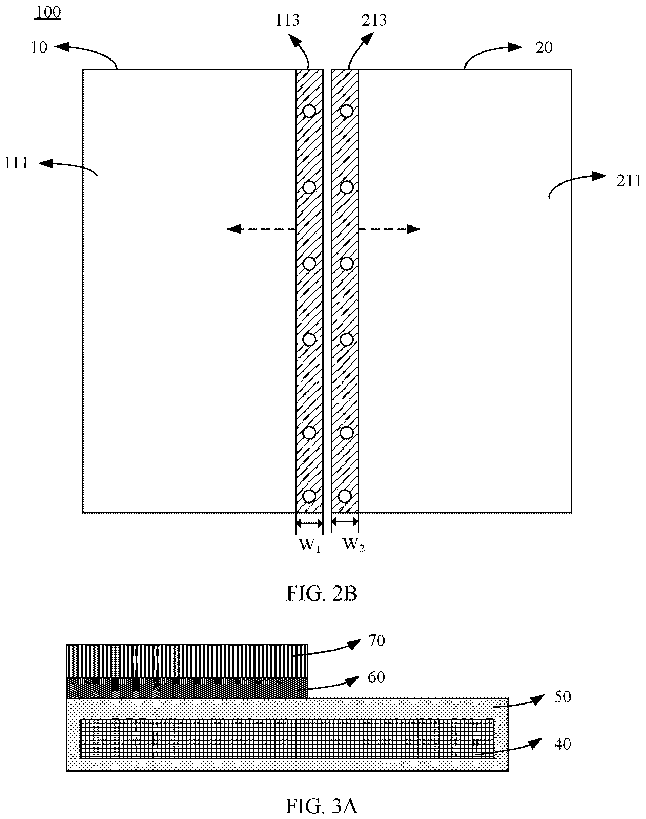

A first region 113 and a second region 213 are defined, the first region 113 including a side border that is of the first surface 111 and that is close to the rotating mechanism 30, and the second region 213 including a side border that is of the second surface 211 and that is close to the rotating mechanism 30. Specifically, referring to FIG. 2A and FIG. 2B, on a side edge that is of the first backplane 11 and that is close to the rotating mechanism 30 (for ease of description, the side edge is denoted as a first side edge of the first backplane 11), on the first surface 111 of the first backplane 11, a region that faces away from the first side edge from a contour line of the first side edge and covers a first width toward a center of the first backplane 11 is the first region 113 (that is, a region of the first width W₁ in a direction of a black dotted arrow in FIG. 2B from the contour line of the first side edge). Correspondingly, on a side edge that is of the second backplane 21 and that is close to the rotating mechanism 30 (for ease of description, the side edge is denoted as a side edge A of the second backplane 21), on the second surface 211, a region that faces away from the side edge A from a contour line of the side edge A of the second backplane 21 and covers a second width toward a center of the second backplane 21 is the second region 113 (that is, a region of the second width W₂ in a direction of a black dotted arrow at the second backplane 21 in FIG. 2B from the contour line of the side edge A). Values of W₁ and W₂ may be adapted and adjusted based on a size of the foldable structural member 100, for example, 0.5 mm to 2.0 mm, so that the first region 113 and the second region 213 cover at least a part of the rotating open region. Specifically, values of W₁ and W₂ may be independently 0.5 mm, 0.6 mm, 0.7 mm, 0.8 mm, 0.9 mm, 1.0 mm, 1.1 mm, 1.2 mm, 1.3 mm, 1.4 mm, 1.5 mm, 1.6 mm, 1.7 mm, 1.8 mm, 1.9 mm, 2.0 mm, or the like. In addition, the first region 113 and the second region 213 may further continuously extend to central positions of the first backplane 11 and the second backplane 21 (that is, W₁ and W₂ are increased) in a direction to which the black dotted arrow points, respectively. Alternatively, the first region 113 and the second region 213 may be reduced toward a side of the rotating mechanism 30 (that is, the first region 113 and the second region 213 are reduced toward the first side edge of the first backplane 11 and the side edge A of the second backplane 21 in a direction that faces away from the black dotted arrow, to reduce W₁ and W₂). In the embodiments of this application, values of W₁ and W₂ may be the same or different. It may be understood that when the foldable structural member 100 is completely folded, the first region 113 is opposite to the second region 213.

Generally, in the foldable structural member 100, to fasten the rotating mechanism 30, screw holes are disposed on the first backplane 11 and the second backplane 21. The screw holes are adapted to screws. The screws are configured to fasten the rotating mechanism 30. In some implementations of this application, referring to FIG. 2B, the first region 113 extends to a side that is of the screw hole and that faces away from the first side edge of the first backplane 11, and the second region 213 extends to a side that is of the screw hole and that faces away from the side edge A of the second backplane 21. In other words, the screw holes are disposed in both the first region 113 and the second region 213. In this way, a galvanic corrosion resistance effect of the rotating open region of the foldable structural member 100 can be further improved, and folding and unfolding of the foldable structural member 100 cannot be affected.

Referring to FIG. 3A to FIG. 3C, the first backplane 11 and the second backplane 21 each include a metal body 40, a first protective layer 50 disposed on a surface of the metal body 40, an injection molding layer 70 disposed on at least a surface of the first protective layer 50 in the first region 113 and the second region 213, and an anti-corrosion layer 60 disposed between the injection molding layer 70 and the first protective layer 50. The metal body 40 provides structural strength for the first middle frame 10 and the second middle frame 20, and plays a specific protective role. When the metal body 40 is applied to the electronic device, the metal body may further serve to assist a processor of the electronic device to radiate heat. The first protective layer 50 may protect the metal body 40, so as to prevent the metal body 40 from being corroded. In particular, the injection molding layer 70 in the first region 113 and the second region 213 may have a better sealing effect, that is, a risk of salt spray, water vapor, or the like infiltrating into the foldable structural member 100 is greatly reduced. Therefore, when a material of the metal body 40 is a magnesium alloy, a risk of galvanic corrosion of the magnesium alloy body in the rotating open region can be sufficiently reduced. However, the anti-corrosion layer 60 may significantly increase an interface bonding force between the first protective layer 50 and the injection molding layer 70, and avoid a case that the injection molding layer 70 and the first protective layer 50 are poorly bonded and layered, thereby significantly reducing the risk of galvanic corrosion of the metal body 40, significantly improving environmental stability of the metal body, and further providing feasibility for the magnesium alloy to be used as the metal body of the rotating open region in the foldable structural member 100.

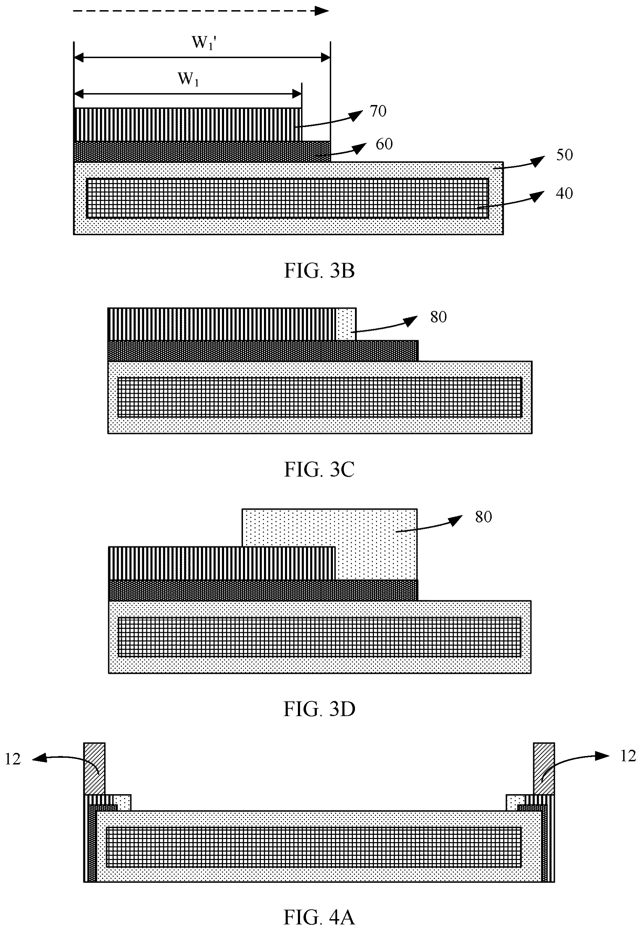

In the embodiments of this application, that the anti-corrosion layer 60 is disposed between the injection molding layer 70 and the first protective layer 50 includes but is not limited to the following case: an orthographic projection of the injection molding layer 70 on the first surface 111 on the metal body 40 falls into an orthographic projection of the anti-corrosion layer 60 on the metal body 40, and specifically, includes but is not limited to the following two cases: (1) as shown in FIG. 3A, the orthographic projection of the injection molding layer 70 on the first surface 111 on the metal body 40 completely coincides with the orthographic projection of the anti-corrosion layer 60 on the metal body 40; an orthographic projection of the injection molding layer 70 on the second surface 211 on the metal body 40 completely coincides with the orthographic projection of the anti-corrosion layer 60 on the metal body 40; (2) as shown in FIG. 3B, the orthographic projection of the injection molding layer 70 on the first surface 111 on the metal body 40 falls into the orthographic projection of the anti-corrosion layer 60 on the metal body 40, and the anti-corrosion layer 60 has a surface that is not covered by the injection molding layer 70; and the orthographic projection of the injection molding layer 70 on the second surface 211 on the metal body 40 falls into the orthographic projection inside of the anti-corrosion layer 60 on the metal body 40, and the anti-corrosion layer 60 has a surface that is not covered by the injection molding layer 70.

In some implementations of this application, on the first surface 111 and/or the second surface 211, the orthographic projection of the injection molding layer 70 on the metal body 40 falls into the orthographic projection of the anti-corrosion layer 60 on the metal body 40 (that is, a part of the surface of the anti-corrosion layer 60 is still not covered by the injection molding layer 70). The following uses the first backplane 11 as an example for detailed description. Referring to FIG. 3B, a width of the first region 113 is W₁, that is, on the first surface 111, in a direction (that is, a direction to which the black dotted arrow points) from the contour line on the first side edge of the first backplane 11 toward a center of the first backplane 11, a width of the injection molding layer 70 is W₁, a width of the anti-corrosion layer 60 is W1', and Wi' is larger than W₁. In this way, a thickness of a central region of the first backplane 11 can be further reduced while an anti-corrosion requirement of the metal body 40 can be met, and more accommodating space is reserved for the first middle frame 10 for accommodating another component such as a processor, thereby reducing a total thickness of the final electronic device and further improving the lightweight degree of the electronic device. Further, a value of Wi'-Wi may be within a range of 0.03 mm to 20 mm. Specifically, a value of W₁'-W₁ may be 0.03 mm, 0.05 mm, 0.10 mm, 0.20 mm, 0.50 mm, 0.80 mm, 1.00 mm, 2.00 mm, 5.00 mm, 8.00 mm, 10.00 mm, 12.00 mm, 15.00 mm, 18.00 mm, 20.00 mm, or the like. On the second surface 211 of the second backplane 21, in a direction from the contour line on the side edge A of the second backplane 21 toward a center of the second backplane 21, the width of the injection molding layer 70 is greater than the width of the anti-corrosion layer 60. Specifically, the case on the second backplane 21 may be adapted based on the foregoing principle, and details are not described herein again. In some specific embodiments, on the first surface 111 of the first backplane 11, at least a part of the region of the first protective layer 50 is not covered by the anti-corrosion layer 60. In addition, on the second surface 211 of the second backplane 21, at least a part of the region of the first protective layer 50 is not covered by the anti-corrosion layer 60. In this way, a total thickness of the final electronic device can be further reduced while the anti-corrosion requirement of the metal body 40 can be met. The lightweight degree of the final electronic device can be further improved, and production costs can be reduced. Certainly, full coverage of the anti-corrosion layer 60 can be implemented on the surface of the first protective layer 50 on the first surface 111 of the first backplane 11 based on actual application. Similarly, full coverage of the anti-corrosion layer 60 can be implemented on the surface of the first protective layer 50 on the second surface 211 of the second backplane 21.

In some other implementations of this application, on the first surface 111 and/or the second surface 211, the orthographic projection of the injection molding layer 70 on the metal body 40 completely coincides with the orthographic projection of the anti-corrosion layer 60 on the metal body 40. In this way, the anti-corrosion layer 60 is also not disposed in a region in which the injection molding layer 70 is not disposed, which helps to reduce production costs. It may be selected based on actual application requirements.

In the embodiments of this application, it should be further noted that the first protective layer 50 is disposed on the surface of the metal body 40. Specifically, all surfaces of the metal body 40 are covered by the first protective layer 50.

In some implementations of this application, the material of the metal body 40 is a magnesium alloy. The magnesium alloy has a smaller density and a high specific strength. The matrix metal is made of a magnesium alloy, which may reduce weights of the first backplane 11 and the second backplane 21 while ensuring strength of the first backplane 11 and the second backplane 21, thereby increasing the lightness and thinness of the electronic device. The magnesium alloy may be a profile magnesium alloy, may be a die cast magnesium alloy, or may be a semi-solid magnesium alloy, which is not limited thereto. In some implementations, the magnesium alloy may be a magnesium aluminum alloy, or may be a magnesium lithium alloy, but is not limited thereto. Specifically, the magnesium alloy may be selected from at least one of an AZ series magnesium alloy, an AM series magnesium alloy, an AE series magnesium alloy, and an AS series magnesium alloy.

In some implementations of this application, the first backplane 11 has a third surface 112 opposite to the first surface 111 and a fourth surface 114 (as shown in FIG. 1D) that connects the first surface 111 to the third surface 112, the fourth surface 114 including the anti-corrosion layer 60 and the injection molding layer 70 that are successively stacked on a surface that is of the first protective layer 50 and that faces away from the metal body 40.

And/or, the second backplane 21 has a fifth surface 212 opposite to the second surface 211 and a sixth surface (not shown in FIG. 1D) that connects the second surface 211 to the fifth surface 212, the sixth surface including the anti-corrosion layer 60 and the injection molding layer 70 that are successively stacked on a surface that is of the first protective layer 50 and that faces away from the metal body 40. In this way, the corrosion resistance of the first middle frame 10 and the second middle frame 20 can be comprehensively improved, so that the final foldable electronic device passes a complete-machine salt spray test.

The following uses the first backplane 11 as an example for detailed description. One end of the first side edge of the first backplane 11 is sequentially connected to a second side edge, a third side edge, and a fourth side edge, where the fourth side edge is connected to the other end of the first side edge. Surfaces of the first side edge, the second side edge, the third side edge, and the fourth side edge jointly constitute the fourth surface 114. It may be understood that, to adequately ensure an anti-corrosion effect of the foldable structural member 100, the fourth surface 114 also needs to perform anti-corrosion processing. Therefore, the surface of the first protective layer 50 of the fourth surface 114 further includes the anti-corrosion layer 60 and the injection molding layer 70 that are successively stacked. Similarly, the second backplane also includes four side edges, and surfaces of the four side edges jointly constitute the sixth surface. A specific case may be adapted based on the foregoing principle, and details are not described herein again.

In some specific implementations, the fourth surface 114 of the first backplane 11 does not expose the metal body 40. In some specific embodiments, further, the anti-corrosion layer 60 and the injection molding layer 70 may further extend from the fourth surface 114 to the first surface 111 of the first backplane 11. A case of the second side edge is used as an example. The anti-corrosion layer 60 and the injection molding layer 70 extend from the fourth surface 114 to an edge region that is of the first surface 111 and that is close to the second side edge, and a width dimension of the region on the first surface 111 may be determined based on an actual application requirement. It should be noted that the injection molding layer 70 on the first side edge is connected to the injection molding layer 70 on the first region 113, so as to improve the anti-corrosion effect. Further, the injection molding layer 70 on the first side edge is seamlessly connected to the injection molding layer 70 on the first region 113. The anti-corrosion layer 60 on the first side edge is seamlessly connected to the anti-corrosion layer 60 on the first region 113. Similarly, the sixth surface of the second backplane does not expose the metal body 40, and a case in which the anti-corrosion layer 60 and the injection molding layer 70 of the second backplane 21 may be adapted based on the foregoing principle. Details are not described herein again.

In some implementations of this application, a thickness of the injection molding layer 70 is within a range of 0.15 mm to 0.35 mm. In this way, the protective performance of the injection molding layer 70 and the lightness and thinness of the foldable structural member 100 can be both considered. Specifically, the thickness of the injection molding layer 70 may be 0.15 mm, 0.18 mm, 0.20 mm, 0.22 mm, 0.25 mm, 0.28 mm, 0.30 mm, 0.32 mm, 0.35 mm, or the like.

Referring to FIG. 1B to FIG. 1C and FIG. 4A, in some implementations of this application, the first middle frame 10 further includes a first side frame 12 fastened to the first backplane 11. The second middle frame 20 further includes a second side frame 22 fastened to the second backplane 21. The first side frame 12, the first backplane 11, the second backplane 21, and the second side frame 22 constitute a first accommodating space. The first side frame 12 and the second side frame 22 are manufactured by injection molding. The first side frame 12 and the second side frame 22 extend toward the first surface 111 of the first backplane 11, and extension directions thereof are perpendicular to the first surface 111. The second side frame 22 extends toward the second surface 211 of the second backplane 21, and an extension direction thereof is perpendicular to the second surface 211. The first side frame 12 and the second side frame 22 have limiting and protecting effects on an outer side border of the display of the electronic device. Specifically, the first accommodating space may be the same as accommodating components such as a first display module and a heat dissipation plate. The first display module includes a first display, and the first display is a flexible screen. In addition, the first side frame 12 and the second side frame 22 further participate in constituting an appearance surface of the foldable electronic device.

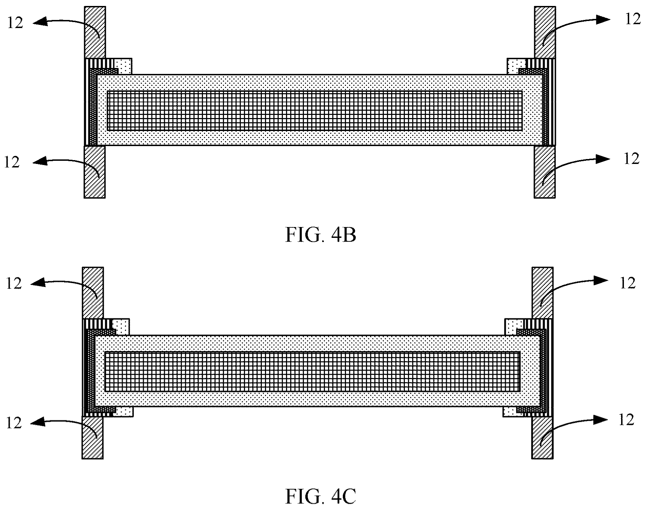

In some implementations of this application, referring to FIG. 4B, the first side frame 12 further extends toward the third surface 112 of the first backplane 11, and the extension direction thereof is further perpendicular to the third surface 112. The second side frame 22 further extends toward the fifth surface 212 of the second backplane 21, and the extension direction thereof is further perpendicular to the fifth surface 212. In this way, the first side frame 12, the first backplane 11, the second side frame 22, and the second backplane 21 further constitute a second accommodating space, and the second accommodating space may be used to accommodate a battery component and the like. When the foldable structural member 100 is fully unfolded, the second accommodating space and the first accommodating space are disposed oppositely. In some specific implementations, a second display module is disposed in the second accommodating space. In this case, the second display module is located on the third surface 112 of the first backplane 11, or is located on the fifth surface 212 of the second backplane 21. Further, referring to FIG. 4C, the anti-corrosion layer 60 and the injection molding layer 70 further extend to the third surface 112 of the first backplane 11, and/or the anti-corrosion layer 60 and the injection molding layer 70 further extend to the fifth surface 212 of the second backplane. Further, the second middle frame 20 may be adapted based on the foregoing principle, and details are not described herein again.

In some implementations of this application, the first side frame 12 is integrally molded with the injection molding layer 70 on the first backplane 11, and the second side frame 22 is integrally molded with the injection molding layer 70 on the second backplane 21. In this way, structural strength of the first middle frame 10 and the second middle frame 20 is further improved. In this case, it may be understood that, a side surface that is of the injection molding layer 70 and that is close to the anti-corrosion layer 60 is a flat surface attached to the first backplane 11 and the second backplane 21, and the first side frame 12 protrudes relative to the first backplane 11, thereby implementing a limiting effect on the display. Similarly, the second side frame 22 protrudes relative to the second backplane 21. The first side frame 12 is seamlessly connected to the injection molding layer 70, and the second side frame 22 is seamlessly connected to the injection molding layer 70.

In some implementations, a material of the injection molding layer 70 is an inorganic material reinforced resin. In some implementations of this application, the material of the injection molding layer 70 is an inorganic fiber reinforced resin. An inorganic fiber includes but is not limited to a glass fiber (GF). The resin includes but is not limited to at least one of a polycarbonate (PC), a polybutylene terephthalate (PBT), a polyphenylene sulfide (PPS), and a polyamide (PA). That is, the material of the injection molding layer 70 may be at least one of a GF-enhanced PC, a GF-enhanced PBT, a GF-enhanced PPS, and a GF-enhanced PA, but is not limited thereto. In this way, corrosion resistance and strength of the injection molding layer 70 may be considered. In some specific embodiments, weight percentage content of the inorganic fiber in the injection molding layer 70 is 10%-60%. Specifically, the weight percentage content of the inorganic fiber in the injection molding layer 70 may be 10%, 12%, 15%, 18%, 20%, 22%, 25%, 28%, 30%, 32%, 35%, 38%, 40%, 42%, 45%, 48%, 50%, 52%, 55%, 58%, 60%, or the like. In this way, the injection molding layer 70 may have better toughness, better compactness, and higher strength.

In some implementations of this application, a material of the first side frame 12 and a material of the second frame 22 are inorganic material reinforced resins. In this case, the first side frame 12 and the second frame 22 have better strength, excellent anti-fall performance, and excellent sealing and corrosion resistance. In addition, when the foldable structural member 100 is used for the electronic device, an antenna module of the electronic device may transmit an electrical signal to the outside by using the first side frame 12 and the second side frame 22, and receive the external electrical signal, so as to implement a communication function of the electronic device. In addition, in this case, a non conductive vacuum metalization (NCVM) system appearance may further be formed on outer surfaces of the first side frame 12 and the second side frame 22, so as to improve the appearance of the final foldable electronic device.

In some implementations of this application, the material of the first side frame 12 and the material of the second side frame 22 are independently selected from at least one of a GF-enhanced PC, a GF-enhanced PBT, a GF-enhanced PPS, and a GF-enhanced PA, which is not limited thereto. In some specific embodiments, the material of the first side frame 12 and the material of the second side frame 22 are the same as the material of the injection molding layer 70. In this case, weight percentage content of the inorganic fiber in the first side frame 12 and weight percentage content of the inorganic fiber in the second side frame 22 may be the same or different. The weight percentage content of the inorganic fiber in the first side frame 12 and the weight percentage content of the inorganic fiber in the second side frame 22 may be the same as or different from weight percentage content of the inorganic fiber in the injection molding layer 70.

In some implementations of this application, the first protective layer 50 is a ceramic layer formed by micro-arc oxidation. The micro-arc oxidation may grow a uniform ceramic layer on the surface of the metal body 40 in situ, and the formed ceramic layer has high hardness, high corrosion resistance, and good insulation performance. In some implementations of this application, resistance of the first protective layer 50 is greater than or equal to 3 MΩ. In some implementations of this application, the material of the first protective layer 50 includes but is not limited to at least one of magnesium silicate, magnesium oxide, magnesium hydroxide, and magnesium chloride.

In some implementations of this application, the first protective layer 50 has a porous structure, the first protective layer 50 has a porosity of less than or equal to 15%, and the porous structure has an aperture of less than or equal to 20 µm. That is, in some specific implementations, the ceramic layer formed by the micro-arc oxidation has a porosity of less than or equal to 15%, and the porous structure has an aperture of less than or equal to 20 µm. Specifically, the porosity may be but is not limited to 1%, 2%, 3%, 4%, 5%, 6%, 7%, 8%, 9%, 10%, 11%, 12%, 13%, 14%, 15%, or the like. Specifically, the aperture of the porous structure may be but is not limited to 0.5 µm, 1.0 µm, 2.0 µm, 3.0 µm, 4.0 µm, 5.0 µm, 6.0 µm, 6.5 µm, 7.0 µm, 8.0 µm, 9.0 µm, 10.0 µm, 11.0 µm, 12.0 µm, 13.0 µm, 14.0 µm, 15.0 µm, 16.0 µm, 17.0 µm, 18.0 µm, 19.0 µm, 20.0 µm, or the like. In some specific implementations, apertures of a plurality of holes in the first protective layer 50 are distributed within a range of 0.5 µm to 20 µm. Further, the apertures may be distributed within a range of 6.6 µm to 20 µm. In this way, on one hand, the first protective layer 50 has a certain amount of pores having relatively large apertures, which can significantly increase an interface bonding force between the anti-corrosion layer 60 and the first protective layer 50. Especially, when the anti-corrosion layer 60 is a resin layer, in a preparation process, materials of the resin layer may flow into the pores (more easily flows into pores with larger apertures, pores having apertures greater than 5 µm). After curing, the bonding force between the anti-corrosion layer 60 and the first protective layer 50 is significantly increased, and the pores can be sealed. On the other hand, small holes having smaller apertures (pores having apertures of less than or equal to 5 µm) are distributed in the first protective layer 50, and an entire porosity of the first protective layer 50 may be adjusted to be within a proper range, so that the first protective layer 50 further has specific compactness. In addition, salt spray and water vapor are not prone to infiltrate into the pores having smaller apertures, so that a risk that fine droplets such as salt spray infiltrating into the surface of the metal body 40 through the first protective layer 50 can be further reduced, and when the material of the metal body 40 is a magnesium alloy, galvanic corrosion can be further reduced, and environmental stability of the final foldable electronic device can be improved.

In some implementations of this application, surface roughness of the first protective layer 50 is greater than or equal to 32A. For example, the surface roughness of the first protective layer 50 is 32A-50A. In this way, the interface bonding force between the first protective layer 50 and the anti-corrosion layer 60 is increased, and the galvanic corrosion in the rotating open region is further reduced.

In some implementations of this application, a thickness of the first protective layer 50 is within a range of 15 µm to 40 µm. In this way, protective performance of the first protective layer 50 can be further improved, salt spray and water vapor are further prevented from penetrating through the first protective layer 50, and a total thickness of the first middle frame 10 and the second middle frame 20 can be ensured to be smaller, thereby considering the lightness and thinness of the final electronic device. It may be understood that, when the first protective layer 50 has a porous structure, the pores of the first protective layer 50 are randomly arranged (pore structures are intersected and distributed in the first protective layer 50, and the pores on the surface of the first protective layer 50 are in typical volcanic hole shapes). When the thickness of the first protective layer 50 is within a proper range, a path that fine droplets such as salt spray need to go when penetrating through the first protective layer 50 can be significantly increased, and more obstacles are also disposed, thereby improving the protective effect. Specifically, the thickness of the first protective layer 50 may be 15 µm, 15.5 µm, 16 µm, 17 µm, 18 µm, 19 µm, 20 µm, 21 µm, 22 µm, 23 µm, 24 µm, 25 µm, 26 µm, 28 µm, 30 µm, 32 µm, 34 µm, 35 µm, 36 µm, 38 µm, 39 µm, or the like. In some specific embodiments of this application, the first protective layer 50 has a porous structure, the first protective layer 50 has a porosity of less than or equal to 15%, the porous structure has an aperture of less than or equal to 20 µm, and the thickness of the first protective layer 50 is within a range of 15 µm to 40 µm.

In the embodiments of this application, the anti-corrosion layer 60 may be a single-layer structure, a double-layer structure, or a three-layer structure, which is not limited thereto.

In some implementations of this application, the anti-corrosion layer 60 is a resin layer (that is, the anti-corrosion layer 60 is a single-layer structure). The material of the resin layer includes a cured product of an epoxy resin, a polyester resin and a silane coupling agent. In this way, in the preparation process, a mixture of an epoxy resin, a polyester resin, and a silane coupling agent may be coated on the surface of the first protective layer 50, and the mixture may be immersed in some pores of the first protective layer 50. In addition, the epoxy resin and the polyester resin have a higher Van der Waals force. After the mixture is cured, the materials of the anti-corrosion layer 60 (that is, the resin layer) are further dispersed in the first protective layer 50, so as to increase the interface bonding force between the anti-corrosion layer 60 and the first protective layer 50. In addition, when the material of the injection molding layer 70 includes the inorganic material reinforced resin, the interface bonding force between the resin in the anti-corrosion layer 60 and the resin in the injection molding layer 70 is good. Therefore, the anti-corrosion layer 60 may serve to bridge the first protective layer 50 and the injection molding layer 70, and a firm anti-corrosion and water-proof structure is formed on a surface of a corresponding region of the metal body 40, thereby greatly reducing a risk of galvanic corrosion of a magnesium alloy body, and ensuring that the final electronic device meets requirement for the whole-machine salt spray test. In addition, the cured product of an epoxy resin, a polyester resin and a silane coupling agent has better water-boiling, high-temperature, and high-humidity resistance properties. In this case, in some implementations of this application, a thickness of the anti-corrosion layer 60 is within a range of 10 µm to 40 µm. Specifically, the thickness of the anti-corrosion layer 60 may be but is not limited to 10 µm, 12 µm, 15 µm, 20 µm, 22 µm, 24 µm, 25 µm, 28 µm, 30 µm, 32 µm, 35 µm, 38 µm, 40 µm, or the like. The thickness of the anti-corrosion layer 60 is controlled to be within the foregoing range, and better corrosion resistance and a higher degree of lightness and thinness can be considered.

In some specific embodiments of this application, a first-type inorganic filler is further distributed in the resin layer, where the first-type inorganic filler includes but is not limited to at least one of a hydrophobic silicon dioxide, talc, and magnesium powder. The first-type inorganic filler may increase coverage of the resin layer in the preparation process of the resin layer, that is, reduce particles caused by ambient dust in a spraying process, thereby increasing flatness of the resin layer (that is, the anti-corrosion layer 60), and improving corrosion resistance of the resin layer (that is, the anti-corrosion layer 60). In addition, the first-type inorganic filler may further form a hydrophobic nanostructure of the anti-corrosion layer 60, thereby improving corrosion resistance of the first-type inorganic filler.

In some implementations of this application, the anti-corrosion layer 60 includes a first resin layer and a second resin layer that are stacked (the anti-corrosion layer 60 is a double-layer structure, which is not shown in FIG. 3A to FIG. 3B), and the first resin layer is in contact with the first protective layer 50. The first resin layer includes a material prepared from an epoxy resin, a polyester resin, and a silane coupling agent. The second resin layer includes a cured product of a first-type acrylic resin and an isocyanate. Hydroxyl molar content of the first-type acrylic resin is greater than or equal to 1.0%. Similarly, the first resin layer may partially infiltrate into voids in the first protective layer 50, so as to implement better bonding force. However, the second resin layer and the injection molding layer 70 may implement better interface bonding force. Therefore, the anti-corrosion layer 60 may cooperate with the first protective layer 50 and the injection molding layer 70 to form a firm anti-corrosion barrier. In this case, a thickness of the first resin layer is within a range of 2 µm to 10 µm, and a thickness of the second resin layer is within a range of 10 µm to 30 µm. Specifically, in the anti-corrosion layer 60 of the double-layer structure, the thickness of the first resin layer may be 2 µm, 3 µm, 4 µm, 5 µm, 6 µm, 7 µm, 8 µm, 9 µm, or the like. Specifically, content of the second resin layer may be 10 µm, 12 µm, 15 µm, 18 µm, 20 µm, 22 µm, 25 µm, 28 µm, or the like.

In some specific embodiments of this application, the first-type inorganic filler is further distributed in the first resin layer. A second-type inorganic filler is further distributed in the second resin layer. The first-type inorganic filler includes but is not limited to at least one of hydrophobic silicon dioxide, talc powder, and magnesium powder. The second-type inorganic filler includes but is not limited to at least one of silicon dioxide, barium sulfate, and titanium dioxide. That is, the first resin layer includes a resin distributed with the first-type inorganic filler, and the resin includes the material prepared from an epoxy resin, a polyester resin, and a silane coupling agent. The second resin layer includes a cured product of a first-type acrylic resin distributed with the second-type inorganic filler and an isocyanate. Similarly, the first-type inorganic filler may increase coverage of the resin layer in the preparation process of the resin layer, that is, reduce particles caused by ambient dust in a spraying process, thereby increasing flatness of the resin layer (that is, the anti-corrosion layer 60), and improving corrosion resistance of the resin layer (that is, the anti-corrosion layer 60). In addition, the first-type inorganic filler may further form a hydrophobic nanostructure of the anti-corrosion layer 60, thereby improving corrosion resistance of the first-type inorganic filler. The second-type inorganic filler may increase a surface dyne value of the second resin layer, thereby increasing an adhesive force between the injection molding layer and the anti-corrosion layer 60, and facilitating the corrosion resistance of the final electronic device.

In some other implementations of this application, a transition layer is further disposed between the first resin layer and the second resin layer (the anti-corrosion layer 60 is a three-layer structure, which is not shown in FIG. 3A to FIG. 3B). That is, the anti-corrosion layer 60 includes a first resin layer, a transition layer, and a second resin layer that are successively stacked, and the first resin layer is in contact with the first protective layer 50. In this case, the transition layer includes a second-type hydroxyacrylic resin. Molar content of a hydroxyl group in the second-type acrylic resin is less than or equal to 1.0%. The transition layer serves to connect the first resin layer to the second resin layer, and further improves stability of the anti-corrosion layer 60 of a three-layer structure. In the three-layer structure, the thickness of the first resin layer is within a range of 2 µm to 10 µm. The thickness of the second resin layer is within a range of 2 µm to 10 µm. A thickness of the transition layer is within a range of 10 µm to 20 µm. Specifically, in the anti-corrosion layer 60 of a three-layer structure, the thickness of the first resin layer and the thickness of the second resin layer may be independently 2 µm, 3 µm, 4 µm, 5 µm, 6 µm, 7 µm, 8 µm, 9 µm, or the like. Specifically, in the anti-corrosion layer 60 of a three-layer structure, the thickness of the transition layer may be 10 µm, 12 µm, 15 µm, 18 µm, 20 µm, or the like.

In the embodiments of this application, the anti-corrosion layer 60 may be prepared by using electrophoresis, or may be prepared by using a coating process.

In the embodiments of this application, an adhesive force between the anti-corrosion layer 60 and the first protective layer 50 is greater than or equal to 4B. In the embodiments of this application, a water-boiling adhesive force between the anti-corrosion layer 60 and the first protective layer 50 is greater than or equal to 4B.

An injection molding process is to place the metal body 40 provided with the first protective layer 50 and the anti-corrosion layer 60 in corresponding regions in an injection molding cavity, and perform injection molding processing on a specified region in a high-temperature and high-pressure environment. In some cases, cracks occur in the anti-corrosion layer 60 in a region adjacent to the injection molding layer 70, and corrosion resistance of the anti-corrosion layer 60 is affected. In other words, when the injection molding layer 70 does not cover all surfaces of the anti-corrosion layer 60, cracks may occur on a surface that is of the anti-corrosion layer 60 and that is adjacent to an edge of the injection molding layer 70. In some implementations of this application, referring to FIG. 3C, a second protective layer 80 is further disposed on the first surface 111 of the first backplane 11. Specifically, on the first surface 111 of the first backplane 11, the second protective layer 80 is further disposed in at least a part of a region that is on a surface on which the anti-corrosion layer 60 is not covered by the injection molding layer 70 and that is adjacent to the injection molding layer 70. Similarly, on the second surface 211 of the second backplane 21, the second protective layer 80 is further disposed in at least a part of a region that is on a surface on which the anti-corrosion layer 60 is not covered by the injection molding layer 70 and that is adjacent to the injection molding layer 70. In this way, the second protective layer 80 may seal a gap that appears on an exposed surface of the anti-corrosion layer 60 caused by injection molding, so as to prevent the salt spray water vapor from infiltrating into the anti-corrosion layer 60 through the gap, thereby greatly reducing a galvanic corrosion speed, and the final electronic device meets the requirements for the whole-machine salt spray test.

In some implementations of this application, the second protective layer 80 is connected to the injection molding layer 70.

In some implementations of this application, referring to FIG. 3D, the second protective layer 80 further covers a surface that is of the injection molding layer 70 and that faces away from the anti-corrosion layer 60. It may be understood that, in this case, the second protective layer 80 may better cover the exposed surface of the anti-corrosion layer 60 at an interface between the injection molding layer 70 and the anti-corrosion layer 60, so as to better prevent salt spray and water vapor from infiltrating into the anti-corrosion layer 60 through the gap. Further, in some specific embodiments, the second protective layer 80 may further cover a surface that is of the injection molding layer 70 and that faces away from the anti-corrosion layer 60.

In some implementations of this application, a thickness of the second protective layer 80 is within a range of 5 µm to 30 µm. Specifically, the thickness of the second protective layer 80 refers to a maximum size of a cross section of the second protective layer 80, and the cross section refers to a surface obtained by cutting the first backplane 11 (or the second backplane 21) by using a plane perpendicular to a thickness direction of the first backplane 11 (or the second backplane 21). Specifically, the thickness of the second protective layer 80 may be 5 µm, 8 µm, 10 µm, 12 µm, 15 µm, 18 µm, 20 µm, 22 µm, 25 µm, 28 µm, 30 µm, 32 µm, 35 µm, 38 µm, 40 µm, or the like. In this way, the lightness and thinness of the final electronic product can be improved while the anti-corrosion effect is fully improved.

In some implementations of this application, the second protective layer 80 includes a fluorine-containing resin. The fluorine-containing resin not only has better compactness, but also has specific hydrophobicity, which further improves waterproof performance and corrosion resistance. Specifically, the fluorine-containing resin includes but is not limited to at least one of a fluoroacrylate, a fluorosilyl acrylate, a fluorocarbamate, a perfluoropolyether, a perfluoropolyoxane, a fluoropolymer, a polytetrafluoroethylene, a polyvinylidene fluoride, a fluorosiloxane, 1,1,1,2,3,4,5,5,5-monofluoro-4-methoxypentan-2-ene, and a perfluorohexanol tridecafluorooctanol.

In some other implementations of this application, the second protective layer 80 includes a cured product of a third-type hydroxyacrylic resin and an isocyanate. Molar content of a hydroxyl group in the third-type hydroxyacrylic resin is greater than or equal to 1.0 (a hydroxyl value is greater than or equal to 33), so as to increase a crosslinking degree of a high molecular chain in the second protective layer, to form a dense macromolecular mesh structure, thereby improving the corrosion resistance. In this case, the second protective layer also has better compactness, and a bonding property between the material of the anti-corrosion layer 60 and the material of the injection molding layer 70 is better. In some implementations of this application, the third-type hydroxyacrylic resin is the same as the first-type hydroxyacrylic resin. Further, the material of the second protective layer 80 is the same as that of the second resin layer in the anti-corrosion layer 60.

In some implementations of this application, the rotating mechanism 30 includes but is not limited to a hinge.

Correspondingly, the embodiments of this application further provide a manufacturing method of the foldable structural member 100, including:
S01: Provide a metal body, and form a first protective layer on a surface of the metal body.
S02: Form an anti-corrosion layer on at least a surface of a first protective layer in a first region and a second region.
S03: Form the injection molding layer 70 on at least a surface of the anti-corrosion layer in the first region and the second region, to manufacture the foldable structural member.

In some implementations of this application, before step S01, the method further includes preprocessing the metal body. It may be understood that when a material of the metal body is a magnesium alloy, corrosion resistance of the magnesium alloy is poor, and therefore, a manufacturer may form a coating (for example, a phosphating layer of the magnesium alloy) on a surface of a magnesium alloy original material. Therefore, preprocessing of the magnesium alloy includes sequentially performing degreasing, washing, peeling, washing, neutralizing, and washing.

In step S01, a micro-arc oxidation process is used to form a first protective layer on a surface of the metal body obtained by preprocessing. Specifically, the pre-processed metal body is placed in an electrolyte immersed in an electrolytic cell. The metal body is used as an anode, and the electrolytic cell is used as a cathode. An electric field is applied to perform micro-arc oxidation, so that a surface layer of the metal body is melted, and a ceramic layer with high hardness, good corrosion resistance, and good electrical insulation performance is formed on the surface of the metal body after an obtained melt is in contact with the electrolyte. In some implementations, the electrolyte includes a solvent, a salt, and a nano additive, where the salt includes but is not limited to at least one of a silicate, a phosphate, and an aluminate. In some implementations, the micro-arc oxidation is performed on the metal body at a current density of 1 A to 5 A. Specifically, the current density may be 1.5 A, 2.0 A, 2.2 A, 2.4 A, 2.5 A, 3.0 A, 3.5 A, 4.0 A, 4.2 A, 4.5 A, 4.8 A, 5.0 A, or the like. In some specific embodiments, the metal body is immersed in the electrolyte containing a salt and a nano additive, and the micro-arc oxidation is performed on the metal body by using a current density of 2 A to 5 A. In this way, a first protective layer with a thickness of 15 µm to 40 µm may be formed on the surface of the metal body.

In some implementations of this application, in step S01, voltage of the electric field does not exceed 1000 V.

In some implementations of this application, in step S01, a duty ratio of the micro-arc oxidation process is within a range of 5%-25%. The duty ratio is a ratio of power-on time to total time in a pulse cycle of the micro-arc oxidation. Specifically, the duty ratio of the micro-arc oxidation process may be 5%, 6%, 10%, 15%, 20%, 22%, 25%, or the like.

In some implementations of this application, in step S01, a temperature of the electrolyte is within a range of 15°C-25°C. Specifically, the temperature of the electrolyte may be 15°C, 18°C, 20°C, 22°C, 25°C, or the like.

In some implementations of this application, in step S01, a pulse frequency used for the micro-arc oxidation is 800 Hz to 1000 Hz. Specifically, the pulse frequency used for the micro-arc oxidation may be 800 Hz, 850 Hz, 900 Hz, 950 Hz, 980 Hz, or the like.

In some implementations of this application, in step S01, a duration of performing the micro-arc oxidation process is 20 min to 40 min. Specifically, the duration of performing the micro-arc oxidation process may be 20 min, 25 min, 30 min, 35 min, 40 min, or the like.

In some implementations of this application, in step S02, the anti-corrosion layer may be manufactured by using an electrophoretic process, and may alternatively be manufactured by using a coating process.

In some implementations of this application, when the anti-corrosion layer is a single-layer structure (the anti-corrosion layer is a resin layer), a first mixture is coated on at least the surface of the first protective layer in the first region and the second region, where the first mixture includes an epoxy resin, a polyester resin, and a silane coupling agent, and is placed at 80°C-120°C to bake for 15 min to 30 min to obtain a cured product of an epoxy resin, a polyester resin, and a silane coupling agent, so as to obtain the anti-corrosion layer. In some specific embodiments of this application, step S02 further includes adding the first-type inorganic filler to the first mixture.

In some implementations of this application, when the anti-corrosion layer is a double-layer structure, the first mixture is coated on at least the surface of the first protective layer in the first region and the second region, and is placed at 80°C-120°C to bake for 15-30 min to obtain a first resin layer, and a second mixture is coated on a surface of the first resin layer. The second mixture includes a cured product of a first-type hydroxyacrylic resin and an isocyanate, and is baked at 80°C-120°C for 30 min to 40 min, so that the cured product of a first-type hydroxyacrylic resin and an isocyanate reacts to obtain a second resin layer, so as to obtain an anti-corrosion layer with a double-layer structure. In some specific embodiments of this application, step S02 further includes adding a first-type inorganic filler to the first mixture; and adding a second-type inorganic filler to the second mixture, where the second-type inorganic filler includes but is not limited to at least one of gas-phase silicon dioxide, barium sulfate, and titanium dioxide.

In some implementations of this application, when the anti-corrosion layer is a three-layer structure, the first mixture is coated on at least the surface of the first protective layer in the first region and the second region, and is placed at 80°C-120°C to bake for 15-30 min to obtain a first resin layer, and a transition layer mixture is coated on a surface of the first resin layer. The transition layer mixture includes a second-type hydroxyacrylic resin, and is placed at 80°C-120°C to bake for 15 min to 30 min to obtain a transition layer. Then, the second mixture is coated on the surface of the transition layer, and is placed at 80°C-120°C to bake for 30 min to 40 min to obtain a second resin layer, so as to obtain an anti-corrosion layer with a three-layer structure.

In some implementations of this application, step S02 further includes forming an anti-corrosion layer in another region on the surface of the first protective layer, so that on the first surface of the first backplane, an orthographic projection of the injection molding layer on the metal body falls into an orthographic projection of the anti-corrosion layer on the metal body, and the anti-corrosion layer has a region not covered by the injection molding layer. In some implementations of this application, step S02 further includes forming an anti-corrosion layer in another region on the surface of the first protective layer, so that on the second surface of the second backplane, an orthographic projection of the injection molding layer on the metal body falls into an orthographic projection of the anti-corrosion layer on the metal body, and the anti-corrosion layer has a region not covered by the injection molding layer.

In some implementations of this application, step S02 further includes forming an anti-corrosion layer on a sidewall of the metal body (that is, a fourth surface of the first backplane and a sixth surface of the second backplane). Further, the anti-corrosion layer on the first sidewall is further extended to an edge of the first surface of the first backplane. It should be noted that the edge of the first surface herein does not include the first region. Similarly, the second backplane may be adapted based on the foregoing situation.

In some implementations of this application, in step S03, forming the injection molding layer on at least a surface of the anti-corrosion layer in the first region and the second region includes: placing the metal body obtained in step S02 into a cavity of the injection molding device, performing injection molding at a mold temperature of 90°C-120°C by using an injection molding pressure of 200 MPa, and controlling a temperature of an injection molding raw material to be 290°C-320°C, so as to form the injection molding layer on the surface of the anti-corrosion layer in the first region and the second region. The injection molding raw material includes but is not limited to inorganic fiber reinforced resin particles. In some implementations of this application, step S03 further includes forming the injection molding layer on the surface of the anti-corrosion layer on the sidewall of the metal body (that is, a fourth surface of the first backplane and a sixth surface of the second backplane). The first backplane is used as an example, and the injection molding layer is formed on the anti-corrosion layer on the fourth surface of the first backplane. Further, the injection molding layer on the fourth surface is further extended to the edge of the first surface of the first backplane. It should be noted that the edge of the first surface herein does not include the first region. Similarly, the injection molding layer on the sixth surface is further extended to an edge of the second surface of the second backplane. It should be noted that the edge of the second surface herein does not include the second region.

In some implementations of this application, step S03 further includes forming a first side frame and a second side frame. In some specific implementations, the first side frame is integrally molded with the injection molding layer, and the second side frame is integrally molded with the injection molding layer, so that the first side frame is seamlessly connected to the injection molding layer, and the second side frame is seamlessly connected to the injection molding layer. In this way, overall structural strength of the first middle frame and the second middle frame is improved.

In some implementations of this application, after step S03, the method further includes step S04: forming a second protective layer in at least a part of a region that is on a surface on which the anti-corrosion layer is not covered by the injection molding layer and that is adjacent to the injection molding layer. Further, the second protective layer is connected to the injection molding layer. Further, the second protective layer is further extended to a surface that is of the injection molding layer and that faces away from the anti-corrosion layer.

In some implementations of this application, in step S04, a process of forming the second protective layer includes: coating a fluorine-containing resin to a specified region, baking for 20 min to 50 min at 40°C to 60°C to obtain the second protective layer; alternatively, coating a fluorine-containing resin in a specified region, and placing at room temperature for more than 24 hours to obtain the second protective layer.

In some other implementations of this application, in step S04, a process of forming the second protective layer includes: coating a third-type hydroxy acrylic resin and an isocyanate in a specified region, baking for 15 min to 30 min at 80°C to 120°C to obtain the second protective layer.

The manufacturing method has simple steps and high process reliability, and is applicable to large-scale industrial production.

The embodiments of this application further provide a foldable electronic device, including the foldable structural member provided in the embodiments of this application.

In some implementations of this application, the foldable electronic device includes but is not limited to a wearable electronic device such as a mobile phone, a notebook computer, a tablet computer, and an electronic watch.

In some implementations of this application, the foldable electronic device is a mobile phone.

In some implementations of this application, the foldable electronic device includes a first display and a second display. The first display is disposed on both a first surface of the first middle frame and a second surface of the second middle frame. The first display is a flexible display. The second display is disposed on a surface that is of the first middle frame and that faces away from the first display (that is, the third surface), or the second display is disposed on a surface that is of the second middle frame and that faces away from the first display (that is, the fifth surface). In this case, the first display may be folded and unfolded as the electronic device is folded and unfolded. It may be understood that a display backplane is further disposed on a surface that is of the first display and that faces the first middle frame and the second middle frame.

In some implementations of this application, the second display is disposed on a surface that is of the first middle frame and that faces away from the first display (that is, the third surface). In this case, a battery is disposed on a surface that is of the second middle frame and that faces away from the first display (that is, the fifth surface). In some other implementations, the second display is disposed on a surface that is of the second middle frame and that faces away from the first display (that is, the fifth surface). In this case, a battery is disposed on a surface that is of the first middle frame and that faces away from the first display (that is, the third surface).

The foregoing descriptions are merely specific implementations of the present invention, but are not intended to limit the protection scope of the present invention. Any variation or replacement readily figured out by a person skilled in the art within the technical scope disclosed in the present invention shall fall within the protection scope of the present invention. Therefore, the protection scope of the present invention shall be subject to the protection scope of the claims.

## Claims

1. A foldable structural member, comprising a rotating mechanism, and a first middle frame and a second middle frame that are rotatably connected to the rotating mechanism; wherein
the first middle frame comprises a first backplane, the first backplane having a first surface; the second middle frame comprises a second backplane, the second backplane having a second surface, and the rotating mechanism lapping over the first surface and the second surface;
a first region and a second region are defined, the first region comprising a side border that is of the first surface and that is close to the rotating mechanism, and the second region comprising a side border that is of the second surface and that is close to the rotating mechanism; and
the first backplane and the second backplane each comprise a metal body, a first protective layer disposed on a surface of the metal body, an injection molding layer disposed on at least a surface of the first protective layer in the first region and the second region, and an anti-corrosion layer disposed between the injection molding layer and the first protective layer.

2. The foldable structural member according to claim 1, wherein the first backplane has a third surface opposite to the first surface, and a fourth surface that connects the first surface to the third surface, the fourth surface comprising the anti-corrosion layer and the injection molding layer that are successively stacked on a surface that is of the first protective layer and that faces away from the metal body;
and/or, the second backplane has a fifth surface opposite to the second surface, and a sixth surface that connects the second surface to the fifth surface, the sixth surface comprising the anti-corrosion layer and the injection molding layer that are successively stacked on a surface that is of the first protective layer and that faces away from the metal body.

3. The foldable structural member according to claim 1 or 2, wherein the first middle frame and the second middle frame further comprise a first side frame fastened to the first backplane and a second side frame fastened to the second backplane, respectively;
the first side frame, the first backplane, the second backplane, and the second side frame constitute a first accommodating space; and
the first side frame and the second side frame are manufactured by injection molding.

4. The foldable structural member according to claim 3, wherein the first side frame is integrally molded with the injection molding layer, and the second side frame is integrally molded with the injection molding layer.

5. The foldable structural member according to any one of claims 1-4, wherein a thickness of the first protective layer is within a range of 15 µm to 40 µm.

6. The foldable structural member according to any one of claims 1-5, wherein the first protective layer is a porous structure, and the first protective layer has a porosity of less than or equal to 15% and an aperture of less than or equal to 20 µm.

7. The foldable structural member according to any one of claims 1-6, wherein the first protective layer is a ceramic layer formed by micro-arc oxidation.

8. The foldable structural member according to any one of claims 1-7, wherein a thickness of the injection molding layer is within a range of 0.15 mm to 0.35 mm.

9. The foldable structural member according to any one of claims 1-8, wherein the injection molding layer is an inorganic material reinforced resin layer.

10. The foldable structural member according to any one of claims 1-9, wherein the anti-corrosion layer is a resin layer; a material of the resin layer comprises a cured product of an epoxy resin, a polyester resin and a silane coupling agent; and a thickness of the anti-corrosion layer is within a range of 10 µm to 40 µm.

11. The foldable structural member according to any one of claims 1-9, wherein the anti-corrosion layer comprises a first resin layer and a second resin layer that are stacked, and the first resin layer is in contact with the first protective layer; the first resin layer comprises a resin distributed with a first-type inorganic filler, the resin comprising materials prepared from an epoxy resin, a polyester resin, and a silane coupling agent, and the first-type inorganic filler comprising at least one of hydrophobic silicon dioxide, talc powder, and magnesium powder; and the second resin layer comprises a cured product of a first-type acrylic resin distributed with a second-type inorganic filler and an isocyanate, the second-type inorganic filler comprising at least one of silicon dioxide, barium sulfate, and titanium dioxide.

12. The foldable structural member according to claim 11, wherein a thickness of the first resin layer is within a range of 2 µm to 10 µm, and a thickness of the second resin layer is within a range of 10 µm to 30 µm.

13. The foldable structural member according to claim 11, wherein a transition layer is further disposed between the first resin layer and the second resin layer, the transition layer comprising a second-type hydroxyacrylic resin; wherein
the thickness of the first resin layer is within a range of 2 µm to 10 µm; the thickness of the second resin layer is within a range of 2 µm to 10 µm; and a thickness of the transition layer is within a range of 10 µm to 20 µm.

14. The foldable structural member according to any one of claims 1-13, wherein on the first surface, a second protective layer is further disposed in at least a part of a region that is on a surface on which the anti-corrosion layer is not covered by the injection molding layer and that is adjacent to the injection molding layer;
and/or, on the second surface, a second protective layer is further disposed in at least a part of a region that is on a surface on which the anti-corrosion layer is not covered by the injection molding layer and that is adjacent to the injection molding layer.

15. The foldable structural member according to claim 14, wherein the second protective layer is connected to the injection molding layer.

16. The foldable structural member according to claim 15, wherein the second protective layer further covers a surface that is of the injection molding layer and that faces away from the anti-corrosion layer.

17. The foldable structural member according to any one of claims 14-16, wherein the second protective layer comprises a fluorine-containing resin, or the second protective layer comprises a cured product of a third-type hydroxyacrylic resin and an isocyanate.

18. The foldable structural member according to any one of claims 14-17, wherein a thickness of the second protective layer is within a range of 5 µm to 30 µm.

19. The foldable structural member according to any one of claims 1-18, wherein screw holes are disposed in the first region and the second region, the screw holes are adapted to screws, and the screws are configured to fasten the rotating mechanism.

20. The foldable structural member according to any one of claims 1-19, wherein a material of the metal body is a magnesium alloy.

21. A manufacturing method of the foldable structural member according to any one of claims 1-20, comprising:
providing a metal body, and forming the first protective layer on a surface of the metal body;
forming the anti-corrosion layer on at least a surface of the first protective layer in the first region and the second region; and
forming the injection molding layer on at least a surface of the anti-corrosion layer in the first region and the second region to manufacture the foldable structural member.

22. The manufacturing method of the foldable structural member according to claim 20, wherein a process of forming the first protective layer on a surface of the metal body comprises:
soaking the metal body in an electrolyte in an electrolytic cell, using the metal body as an anode, using the electrolytic cell as a cathode, applying an electric field, and performing micro-arc oxidation on the metal body at a current density greater than 2 A and less than or equal to 5 A; wherein the electrolyte comprises a solvent, a salt, and a nano additive; and the salt comprises at least one of silicate, phosphate, and aluminate.

23. A foldable electronic device, comprising the foldable structural member according to any one of claims 1-19.

24. The foldable electronic device according to claim 23, comprising a first display and a second display; wherein the first display is a flexible display;
the first display is disposed on a first surface of the first middle frame and a second surface of the second middle frame; and
the second display is disposed on a surface that is of the first middle frame and that faces away from the first display, or the second display is disposed on a surface that is of the second middle frame and that faces away from the first display.
